# EUROPEAN PATENT SPECIFICATION

(11) **EP 2 847 869 B1**
(45) Date of publication and mention of the grant of the patent: **16.05.2018**
(21) Application number: 12873202.1
(22) Date of filing: 27.03.2012
(51) Int. Cl.: H04B 1/04, H04B 1/44, H04B 1/18, H03H 7/40

(54) **A TRANSCEIVER WITH AN INTEGRATED RX/TX CONFIGURABLE PASSIVE NETWORK**
SENDER-EMPFÄNGER MIT INTEGRIERTEM KONFIGURIERBAREM RX/TX-PASSIVNETZWERK
EMETTEUR-RÉCEPTEUR ÉQUIPÉ D'UN RÉSEAU PASSIF RX/TX CONFIGURABLE INTÉGRÉ

(43) Date of publication of application: 18.03.2015
(73) Proprietor: Intel Corporation, Santa Clara, CA 95052 (US)
(72) Inventor: GEDDADA, Hemasundar Mohan, College Station, Texas 77840 (US); XU, Hongtao, Beaverton, Oregon 97006 (US); FU, Chang-Tsung, Portland, Oregon 97229 (US); TAYLOR, Stewart S., Beaverton, Oregon 97006 (US)
(74) Representative: Goddar, Heinz J.
(86) International application number: PCT/US2012/030732
(87) International publication number: WO 2013/147751

(56) References cited:
- WO-A1-2011/063305
- US-A1- 2006 135 084
- US-A1- 2011 281 531
- US-A1- 2011 285 475
- US-B1- 8 135 357
- US-B1- 8 135 357
- US-B2- 7 248 845

## Description

### Technical Field

The present disclosure relates generally to the technical field of electronics. More specifically, the present disclosure relates to a transceiver having an integrated configurable passive network.

### Background Information

A radio frequency (RF) front end may include a transceiver coupled to an antenna. A radio transceiver may include a transmitter, a receiver, and a transmit/receive (T/R) switch coupled electrically in series between the antenna, transmitter, and/or receiver. The T/R switch may multiplex an antenna to the transmitter or multiplex the antenna to the receiver. A typical T/R switch may introduce loss during both the transmitting function and receiving function of the transceiver by adding resistance and parasitic capacitive loads to the signal paths. These losses may degrade overall power efficiency and noise figure. To overcome these losses, conventional approaches may employ large T/R switches with low ON resistance (e.g., less than 5 ohms). A T/R switch may also need to support high transmitter RF power, e.g. power greater than 4 watts, so thick-gate (TG) or cascoded transistors may be used. However, cascode transistors consume silicon real-estate and TG transistors may degrade performance. In particular, TG transistors may contribute to large parasitic capacitances which may degrade noise factor, linearity and isolation performance of the transceiver.

Document US 2011/0281531 discloses a transceiver comprising a transformer, a switch, a PA, and an LNA and utilizes OFF and ON state of the switch to achieve impedance matching for both a receiving state and an emitting state of the transceiver.

### Brief Description of the Drawings

Embodiments of the invention are illustrated by way of example, and not by way of limitation, in the figures of the accompanying drawings in which like reference numerals refer to similar elements.
Figure 1 is a schematic diagram of a transceiver system suitable for use to practice various embodiments of the present disclosure.
Figures 2A and 2B are schematic diagrams of the transceiver system of Figure 1 in various states, according to various embodiments of the present disclosure.
Figure 3 is a flow diagram of a method of operating a transceiver, according to various embodiments of the present disclosure.
Figure 4 is a block diagram of a computing arrangement incorporated with various embodiments of the present disclosure.

### Description of the Embodiments

Embodiments of the present disclosure may relate to a radio frequency (RF) front-end. In embodiments, the radio frequency (RF) front-end may include a transceiver having a transmitter amplifier and a receiver amplifier. A transmission line may be coupled between the transmitter amplifier, receiver amplifier, and an antenna. A passive network may also be coupled between the transmitter amplifier and receiver amplifier and be configurable to cancel a reactance of a parasitic capacitance of the transmitter amplifier or to cancel a reactance of a parasitic capacitance of the receiver amplifier. The passive network may be switchably coupled to a voltage reference, such as ground, to enable operation of the transceiver without having a switch coupled in series between the antenna, the transmitter amplifier, and/or the receiver amplifier. The integrated T/R switch may be positioned in the transceiver so as to multiplex the antenna between the transmitter amplifier and the receiver amplifier without using an in-line switch, that is, a switch that is electrically coupled in series between the antenna, the transmitter amplifier and/or the receiver amplifier. Accordingly, the integrated T/R switch may have high linearity (e.g., 1 dB compression point, P_{1dB}) and low insertion loss (e.g., less than .5 dB in transmit mode).

Various aspects of the illustrative embodiments will be described using terms commonly employed by those skilled in the art to convey the substance of their work to others skilled in the art. However, it will be apparent to those skilled in the art that some alternate embodiments may be practiced using with portions of the described aspects. For purposes of explanation, specific numbers, materials, and configurations are set forth in order to provide a thorough understanding of the illustrative embodiments. However, it will be apparent to one skilled in the art that alternate embodiments may be practiced without the specific details. In other instances, well-known features are omitted or simplified in order to not obscure the illustrative embodiments.

Further, various operations will be described as multiple discrete operations, in turn, in a manner that is most helpful in understanding the illustrative embodiments; however, the order of description should not be construed as to imply that these operations are necessarily order dependent. In particular, these operations need not be performed in the order of presentation.

The phrase "in one embodiment" is used repeatedly. The phrase generally does not refer to the same embodiment; however, it may. The terms "comprising," "having," and "including" are synonymous, unless the context dictates otherwise. The phrase "A/B" means "A or B". The phrase "A and/or B" means "(A), (B), or (A and B)". The phrase "at least one of A, B and C" means "(A), (B), (C), (A and B), (A and C), (B and C) or (A, B and C)". The phrase "(A) B" means "(B) or (A B)", that is, A is optional.

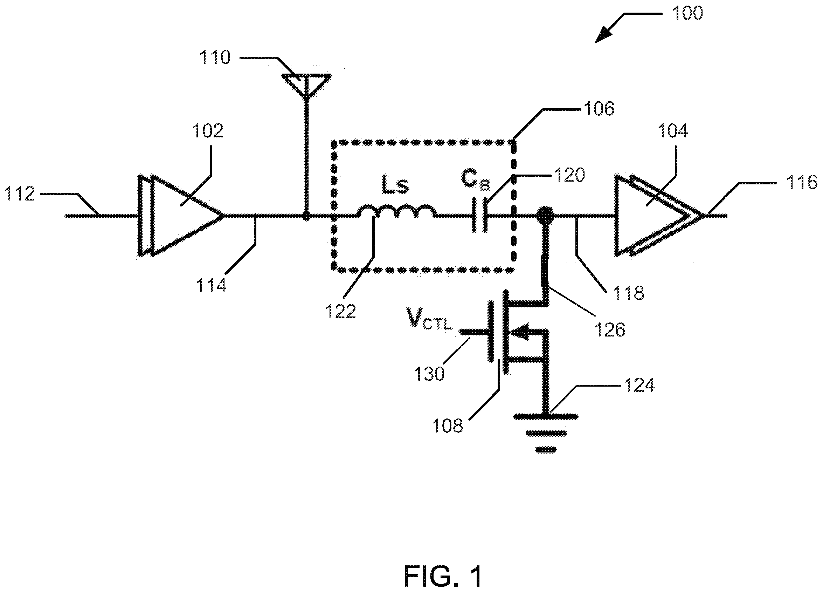

Figure 1 illustrates a transceiver system 100 suitable for practicing embodiments of the present disclosure. As will be described in more detail below, transceiver system 100 may be configured to selectively couple a transmitter amplifier to an antenna without coupling a switch electrically in series between the transmitter amplifier and the antenna. Transceiver system 100 may also be configured to selectively couple a receiver amplifier to the antenna without coupling a switch in electrical series between the receiver amplifier and the antenna. Thus, transceiver system 100 may be configured to operate with better power efficiency and noise figure, and less insertion losses than conventional transceivers. As shown, in embodiments, transceiver system 100 may include a transmitter amplifier 102, a receiver amplifier 104, a passive network 106, a switch 108, and an antenna 110 coupled with each other as shown.

Transmitter amplifier 102 may be configured to selectively output radio frequency (RF) signals to antenna 110. Transmitter amplifier 102 may include an input terminal 112 and an output terminal 114. Transmitter amplifier 102 may receive various RF signals, i.e., analog signals, on input terminal 112. For example, transmitter amplifier 102 may receive various RF signals from a signal processor, signal generator, mixer, analog filter, another transmitter amplifier, or the like. According to one embodiment, transmitter amplifier 102 may be one component of a radio frequency transmitter. Transmitter amplifier 102 may be configured to increase the voltage gain of the received RF signals, increase the current gain of the received RF signals, or concurrently increase both of the voltage gain and the current gain of the received RF signals.

Transmitter amplifier 102 may then output the amplified RF signals onto output terminal 114. Output terminal 114 may be directly coupled or connected to antenna 110 without any switches coupled electrically in series between output terminal 114 and antenna 110. According to one embodiment, output terminal 114 may be directly coupled to antenna 110 without any active switches, such as transistors, in electrical series between output terminal 114 and antenna 110. Output terminal 114 may be coupled or connected to antenna 110 through one or more transmission lines or conductive connections. In various embodiments, output terminal 114 may be inductively coupled to antenna 110. In various other embodiments, output terminal 114 may be coupled or connected to antenna 110 through one or more filters, such as a balun filter.

According to one embodiment, transmitter amplifier 102 may be a switch-mode power amplifier. According to another embodiment, transmitter amplifier 102 may be a linear amplifier. Transmitter amplifier 102 may be configured to have a high impedance OFF state, so output terminal 114 is tri-stated (e.g., for switch-mode amplifiers) or in an off-state (e.g., for linear amplifiers). In various non-limiting example embodiments, high impedance may refer to an impedance characteristic of transmitter 102 with respect to a load. As non-limiting examples, high impedance may be 1 kohm to a 10 ohm load, 1 Mohm to a 1 kohm load, or the like. In other embodiments, high impedance may refer to an absolute impedance of transmitter amplifier 102 and may include any impedance greater than several hundred kiloohms, any impedance greater than approximately 1 Mohm, any impedance greater than approximately several Mohms, or the like.

Receiver amplifier 104 may be configured to receive RF signals, or other analog signals, from antenna 110. Receiver amplifier 104 may include one or more switches configured to amplify the voltage and/or current of RF signals received by antenna 110. Receiver amplifier 104 may also include one or more switches configured to decouple receiver amplifier 104 from one or more voltage supplies to disable or turn OFF receiver amplifier 104. According to one embodiment, receiver amplifier 104 may be a low noise amplifier portion of an RF receiver.

Receiver amplifier 104 may include an output terminal 116 and an input terminal 118. Output terminal 116 may be coupled to various demodulation circuitry and/or other signal processing circuitry suitable for interpreting data carried by the RF signals. Input terminal 118 may be coupled to antenna 110 via one or more transmission lines. Input terminal 118 may be conductively coupled to antenna 110 without a switch coupled in electrical series between input terminal 118 and antenna 110. Through input terminal 118, receiver amplifier 104 may be directly coupled or connected to passive network 106 and switch 108 to selectively receive RF signals from antenna 110.

Passive network 106 may be coupled between receiver amplifier 104, transmitter amplifier 102, and antenna 110, according to various embodiments. Passive network 106 may be configured to offset and/or cancel the effects of parasitic capacitances existing within transceiver system 100. In particular, passive network 106 may be configured to perform impedance matching on the communication path and/or transmission lines which couple together transmitter amplifier 102, receiver amplifier 104, and antenna 110. According to another embodiment, passive network 106 may be configured to filter various frequencies of RF signals received and transmitted by transceiver system 100. For example, passive network 106 may be configured as a low pass filter, a high pass filter, or a bandpass filter to selectively allow signals within a particular frequency range to be transmitted and received by antenna 110. According to various non-limiting example embodiments, passive network 106 may be configured to selectively allow signals to be transmitted that have a frequency range of 2.3 GHz to 2.6 GHz for Wi-Fi® or Bluetooth®, 700 MHz to 2.7 GHz wireless telephone communications, or other radio frequency ranges.

Passive network 106 may include a blocking capacitor 120 and a series inductor 122. The blocking capacitor 120 may include one or more capacitors electrically coupled in parallel and/or series. The capacitance of blocking capacitor 120 may be large in value to provide direct current (DC) biasing to transistors within receiver amplifier 104. In embodiments, blocking capacitor 120 may function to block DC signals from passing to receiver amplifier 104. For example, blocking capacitor 120 may be configured to block or isolate DC signals from passing to receiver amplifier 104 from transmitter amplifier 102. At a frequency of operation, blocking capacitor 120 may function as a short circuit between series inductor 122 and input terminal 118. Blocking capacitor 120 may be coupled between input terminal 118 and series inductor 122. Blocking capacitor 120 may also be coupled between switch 108 and series inductor 122. Blocking capacitor 120 may include a metal capacitor, a metal-insulator-metal capacitor, a poly-poly capacitor, a field effect transistor configured as a capacitor, or the like. According to various non-limiting embodiments, the frequency of operation may include a range of frequencies spanning portions or all of the ranges of 2.3 GHz to 2.6 GHz, 700 MHz to 2.7 GHz, or other radio frequency ranges.

Series inductor 122 may be configured to selectively perform a number of functions. For example, series inductor 122 may be configured to selectively block or filter signals having a range of frequencies from propagating to input terminal 118. Series inductor 122 may be coupled to input terminal 118 for input impedance matching, bandwidth extension, or to resonate out (cancel) the input parasitic capacitance of receiver amplifier 104. Series inductor 122 may also work in conjunction with blocking capacitor 120 to form a bandpass filter for signals that are transmitted and received by antenna 110. Series inductor 122 may be coupled between blocking capacitor 120 and antenna 110. Series inductor 122 may also be coupled between blocking capacitor 120 and transmitter amplifier 102.

Series inductor 122 may be sized and configured to perform impedance matching on transmission lines coupling antenna 110 to transmitter amplifier 102. In particular, series inductor 122 may be configured to cancel a reactance of a parasitic capacitance associated with transmitter amplifier 102. Additionally, series inductor 122 may be configured to cancel a reactance of a parasitic capacitance associated with receiver amplifier 104, according to various embodiments.

Switch 108 may be configured to selectively couple or decouple passive network 106 and input terminal 118 to a voltage reference 124. In one embodiment, voltage reference 124 may be ground, such as a direct current (DC) ground. In another embodiment, voltage reference 124 may be non-DC ground but may instead be an alternating current (AC) ground with a DC bias, such as voltage supply. In other embodiments, voltage reference 124 may include a virtual ac ground between differential signals. Switch 108 may be configured as a shunt switch, selectively coupling and decoupling passive network 106 to voltage reference 124.

According to various embodiments, switch 108 may be a metal oxide semiconductor field effect transistor (MOSFET). In particular, switch 108 may be a P-channel MOSFET or an N-channel MOSFET, and each component of the transceiver system 100 may be manufactured from a complementary metal oxide semiconductor (CMOS) process. Switch 108 may also be a junction-gate field effect transistor (JFET), a bi-polar junction transistor (BJT), or other similar transistor, according to various other embodiments of the disclosure. According to one embodiment, switch 108 does not employ remote body contacts to improve isolation and power handling capability of switch 108.

Switch 108 may have a first conductive terminal 126, a second conductive terminal 128, and a control terminal 130. First conductive terminal 126 may be directly coupled or connected to input terminal 118. Switch 108 may be configured to selectively couple conductive terminal 126 to conductive terminal 128 in response to receiving a control signal Vctl at control terminal 130. According to another embodiment, switch 108 may be connected between series inductor 122 and capacitor 120. By selectively coupling input terminal 118 to voltage reference 124, switch 108 may prevent the output of transmitter amplifier 102 from being received by receiver amplifier 104.

Operation of switch 108 may toggle transceiver system 100 between a transmit mode and a receive mode. According one embodiment, switch 108 may couple input terminal 118 to voltage reference 124 during the transmit mode. In other words, switch 108 may couple input terminal 118 to voltage reference 124, such as ground, while transmitter amplifier 102 outputs RF signals to output terminal 114. Coupling input terminal 118 to voltage reference 124 during transmit mode may protect receiver amplifier 104 from becoming damaged by the output of transmitter amplifier 102. According to another embodiment, switch 108 may decouple input terminal 118 from voltage reference 124 during the receive mode. Switch 108 may decouple input terminal 118 from voltage reference 124 while transmitter amplifier 102 is OFF to enable receiver amplifier 104 to receive RF signals from antenna 110.

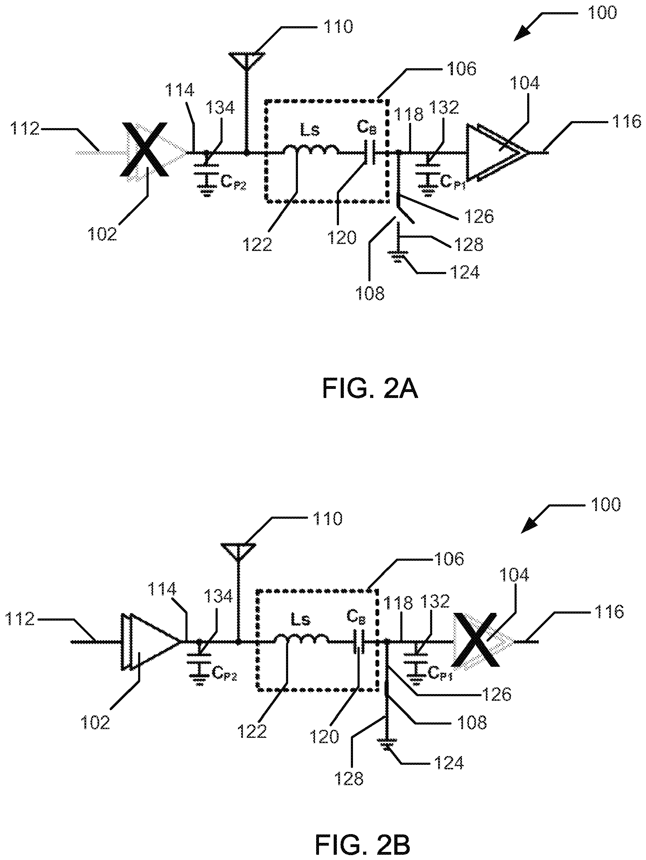

The position of switch 108 within transceiver system 100 may provide advantages over conventional transceiver designs. For example, because switch 108 is not positioned in-line, i.e. electrically in series, with transmitter amplifier 102 and antenna 110, switch 108 may not have to be designed with a high breakdown voltage (e.g., greater than 20 volts) and a correspondingly wide conductive channel. Characteristics such as high breakdown voltage and a wide conductive channel of transmit/receive (T/R) switches in conventional transceivers contribute to large parasitic capacitances and decreased power efficiency and noise figure. To the contrary, switch 108 may be a relatively small transistor with a thin gate. As will be described in more detail below with references to Figures 2A and 2B, the integrated co-design of passive network 106 may enable the reuse of blocking capacitor 120 and series inductor 122 for both the receive mode and transmit mode of the transceiver while employing switch 108 in a non-invasive manner.

The transmitter amplifier 102, receiver amplifier 104, passive network 106, and switch 108 may be integrated at least in part because switch 108 is fabricated concurrently with transistors of transmitter amplifier 102 and receiver amplifier 104. These components may be identified as co-designed because they may together perform functions that are conventionally performed by more components than are used by transceiver system 100. For example, a conventional receiver may use a dedicated inductor and capacitor to perform input filtering and a conventional transmitter may use a dedicated inductor to perform impedance matching. However, as shown, transceiver system 100 reduces the number of components used for transceiving by reusing passive network 106 for multiple functions.

Figures 2A and 2B illustrate the receive mode and transmit mode of transceiver system 100, according to various embodiments. Figures 2A and 2B also illustrate switch 108 multiplexing antenna 110 between receiver amplifier 104 and transmitter amplifier 102.

Figure 2A illustrates transceiver system 100 in the receive mode, according to one embodiment. In receive mode, switch 108 may be in an OFF state, e.g. Vctl = 0 volts, such that conductive terminal 126 may be decoupled from conductive terminal 128. Additionally, in receive mode, transmitter amplifier 102 may be disabled so that output terminal 114 may be in a high impedance state. Transmitter amplifier 102 may be disabled by switchably decoupling transmitter amplifier 102 from one or more voltage supplies and from one or more voltage references, according to one embodiment.

While in the receive mode, RF signals received from antenna 110 may propagate through passive network 106 to receiver amplifier 104. In this mode, series inductor 122 resonates out a parasitic capacitance 132 at input terminal 118. In other words, series inductor 122 may be configured to cancel the reactance of parasitic capacitance 132 by impedance matching. Parasitic capacitance 132 may include: the capacitance of transmission lines that are coupled to input terminal 118, the capacitance of switch 108, and/or the capacitances of transistors included in receiver amplifier 104. By resonating out parasitic capacitance 132, series inductor 122 of passive network 106 may improve the gain and noise figure of receiver amplifier 104. According one embodiment, receiver amplifier 104 may be a low noise amplifier. Advantageously, since there are no switches coupled in series between antenna 110 and receiver amplifier 104, performance of receiver amplifier 104 may be improved over conventional transceivers in sensitivity, noise figure, linearity and gain.

Figure 2B illustrates transceiver system 100 in the transmit mode, according to one embodiment. In transmit mode, switch 108 may be in an ON state, e.g. Vctl = 1 volt, such that conductive terminal 126 is coupled to conductive terminal 128 and to voltage reference 124. Additionally, in transmit mode, receiver amplifier 104 may be disabled so that receiver amplifier 104 is not amplifying noise. According to one embodiment, coupling input terminal 118 to voltage reference 124 may disable receiver amplifier 104. According to another embodiment, receiver amplifier 104 may be disabled by switchably decoupling receiver amplifier 104 from one or more voltage supplies and from one or more voltage references with transistors included in receiver amplifier 104.

While in the transmit mode, series inductor 122 may be configured to be electrically in parallel with a parasitic capacitance 134. In this configuration, blocking capacitor 120 may be an electrical short circuit at the frequency of operation. The parallel shunt configuration of series inductor 122 may resonate out parasitic capacitance 134. In other words, series inductor 122 may be configured to cancel the reactance of parasitic capacitance 134. In this configuration, series inductor 122 may also provide high impedance isolation between transmitter amplifier 102 and receiver amplifier 104. This high impedance may be approximated as 2π*Ls*f, where Ls is the inductance of series inductor 122 and f is the frequency of operation. Advantageously, because series inductor 122 is a passive element it may be able to withstand high power levels (e.g., greater than 4 watts) output by transmitter amplifier 102 without breakdown issues typically associated with conventional T/R transceiver switches. As shown, in transmit mode, switch 108 may protect receiver amplifier 104 by grounding any high signal swings (e.g., 20 volts peak to peak) that may leak through series inductor 122 from transmitter amplifier 102.

Most of the transceiver system 100 may be fabricated in CMOS technology to provide a completely integrated radio. This is in contrast to some techniques where discrete switches are fabricated with a technology that is different from the transceiver. In receiver mode, the receiver amplifier 104 may only experience the effects of the series inductor 122. Series inductor 122 may have at least two benefits in this mode. First, series inductor 122 may not be lossy, like a series T/R switch between an antenna and a receiver amplifier. Second, series inductor 122 may help resonate out, or cancel, the input parasitic capacitance of receiver amplifier 104. The series inductor 122 therefore may improve impedance matching, bandwidth, gain, and noise figure. Furthermore, as a passive component, series inductor 122 may not inject linearity limitations into transceiver system 100.

In transmit mode, series inductor 122 may offer several advantages over a design with a switch coupled in series between a transmitter amplifier and an antenna. For example, series inductor 122 may be able to withstand high voltages without any break down issues. As another example, the inductance of series inductor 122 may resonate out parasitic capacitance 134 at transmitter amplifier 102. Thus, series inductor 122 may help to improve the output matching of transmitter amplifier 102. Compared with conventional designs, transceiver system 100 may lack losses associated with a series switch so that overall transmission power efficiency may be improved. Furthermore, isolation between transmitter amplifier 102 and receiver amplifier 104 may be improved without any power leakages due to parasitic characteristics of a switch coupled in series of the transmission path. In transmit mode, the signal swing at the drain of switch 108 may be small. Thus, switch 108 may be fabricated as a thin gate transistor.

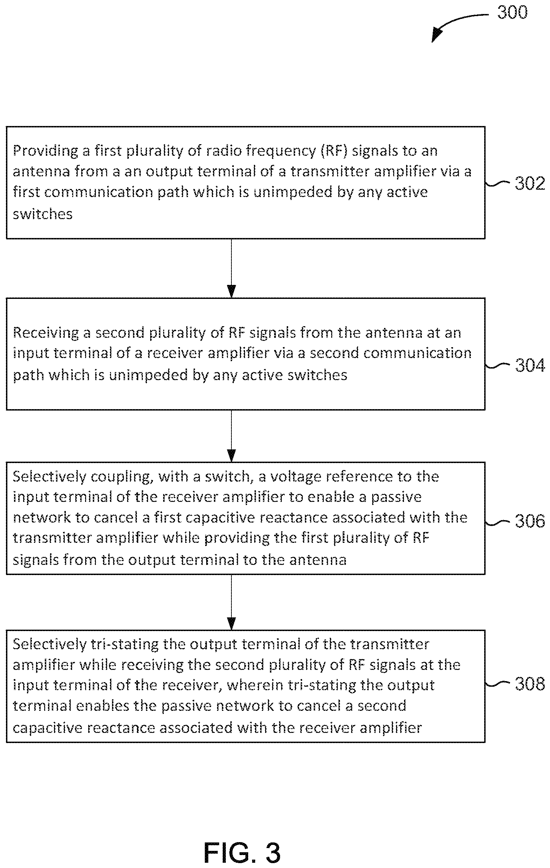

Figure 3 shows a flow diagram of a method for operating transceiver system 100, according to various embodiments.

At block 302, transceiver system 100 may provide a first plurality of radio frequency (RF) signals to an antenna from a an output terminal of a transmitter amplifier via a first communication path which is unimpeded by any active switches.

At block 304, transceiver system 100 may receive a second plurality of RF signals from the antenna at an input terminal of a receiver amplifier via a second communication path which is unimpeded by any active switches.

At block 306, transceiver system 100 may selectively couple, with a switch, a voltage reference to the input terminal of the receiver amplifier to enable a passive network to cancel a first capacitive reactance associated with the transmitter amplifier while providing the first plurality of RF signals from the output terminal to the antenna.

At block 308, transceiver system 100 may selectively tri-state the output terminal of the transmitter amplifier while receiving the second plurality of RF signals at the input terminal of the receiver, wherein tri-stating the output terminal enables the passive network to cancel a second capacitive reactance associated with the receiver amplifier.

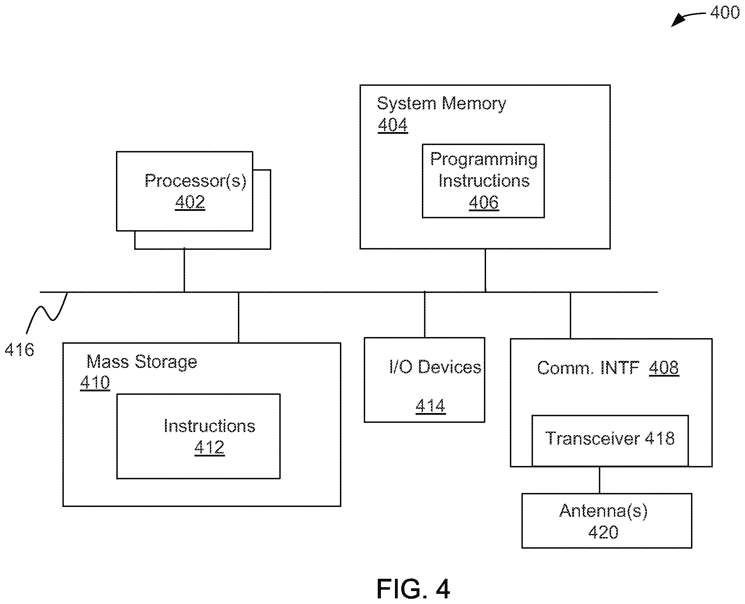

Figure 4 illustrates an example computing device 400 suitable to use transceiver system 100, in accordance with various embodiments of the present disclosure. As shown, computing device 400 may include a number of processors or processor cores 402, a system memory 404 having processor-readable and processor-executable instructions 406 stored therein, and a communication interface 408. For the purpose of this application, including the claims, the terms "processor" and "processor cores" may be considered synonymous, unless the context clearly requires otherwise.

The mass storage 410 may comprise a tangible, non-transitory computer-readable storage device (such as a diskette, hard drive, compact disc read only memory (CDROM), hardware storage unit, and so forth). Mass storage 410 may include instructions 412 to cause process cores 402 to perform the application and/or operating system processes associated with providing RF signals to transmitter amplifier 102, receiving RF signals from receiver amplifier 104, and operating switch 108 of a transceiver of the present disclosure, disposed in communication interface 408. Computing device 400 may also comprise input/output devices 414 (such as a keyboard, display screen, cursor control, touch screen, and so forth).

The various elements of Figure 4 may be coupled to each other via a system bus 416, which represents one or more buses. In the case of multiple buses, they may be bridged by one or more bus bridges (not shown). Data may pass through the system bus 416 through the processors 404.

The system memory 404 may be employed to store a working copy and a permanent copy of the programming instructions implementing one or more operating systems, firmware modules or drivers, applications, and so forth, herein collectively denoted as 406. In particular, some of the modules or drivers may be configured to perform operations that involve RF signal generation and decoding. The permanent copy of the programming instructions may be placed into permanent storage in the factory, or in the field, through, for example, a distribution medium (not shown), such as a compact disc (CD), or through the communication interface 408 (from a distribution server (not shown)). According to one embodiment, instructions 406 and programming instructions 416 include overlapping sets of instructions.

Transceiver 418 may be configured to transmit and receive data via one or more sets of wireless signals. Transceiver 418 may be disposed within communication interface 408, and communicate with other components of computing system 400 via system bus 416. Transceiver 418 may transmit and receive data via one or more sets of wireless signals through one or more antennas 420. According to one embodiment, transceiver 418 and antenna 420 may be transceiver system 100.

According to various embodiments, one or more of the depicted components of computing device 400 and/or other element(s) may include a keyboard, LCD screen, nonvolatile memory port, multiple antennas, graphics processor, application processor, speakers, or other associated mobile device elements, including a camera. For example, computing device 400 may be a Wi-Fi device configured to transmit and receive wireless signal that are compliant with Institute of Electrical and Electronics Engineers (IEEE) standard 802.11. Computing device 400 may also be a smart phone, cell phone, personal digital assistant, table computing device, laptop, netbook, or other mobile device that may wirelessly transmit and receive data.

The remaining constitution of the various elements of computing device 400 is known, and accordingly will not be further described in detail.

Specific features of any of the above described embodiments may be fully or partially combined with one or more other embodiments, either wholly or partially, to form new embodiments of the disclosure.

Following are additional example embodiments of the disclosure.

One example embodiment may be an apparatus that includes a transmitter amplifier having an output terminal communicatively coupled to a transmission line to output a first set of radio frequency (RF) signals to an antenna. The apparatus may include a receiver amplifier having an input terminal communicatively coupled to the transmission line to receive a second set of RF signals from the antenna. The apparatus may include a passive network coupled between the transmitter amplifier and the receiver amplifier with the passive network being configurable to cancel either a first reactance of a parasitic capacitance of the transmitter amplifier or second reactance of a parasitic capacitance of the receiver amplifier. The apparatus may also include a switch coupled between the input terminal and a voltage reference to selectively configure the passive network to cancel either the first reactance or the second reactance.

According to another example, the apparatus may include a capacitor coupled between the passive network and the input terminal with the capacitor being configured to substantially block propagation of direct current (DC) signals between the antenna and the input terminal. The switch may be coupled to the voltage reference between the capacitor and the input terminal. The voltage reference may include either a direct current (DC) reference or an alternating current (AC) reference with a DC bias.

According to another example, the output terminal of the apparatus may be electrically connected to a first terminal of the passive network, via the transmission line, without an intervening switch.

According to another example, the input terminal of the apparatus may be electrically connected to a second terminal of the passive network through a capacitor and via the transmission line.

According to another example, the passive network of the apparatus may include an inductor.

According to another example, the transmitter amplifier of the apparatus may include a power amplifier.

According to another example, the receiver amplifier of the apparatus may include a low noise amplifier.

According to another example, the switch of the apparatus may be coupled between the input terminal and the voltage reference to selectively configure the passive network to cancel either the first reactance or the second reactance, via electrical resonance.

One example embodiment of an apparatus may include a transmitter amplifier having an output terminal and configured to output a first set of radio frequency signals to an antenna. The apparatus may include a first transmission line connected to the output terminal, and a passive network configurable to either reduce a first capacitive reactance or a second capacitive reactance with the passive network having a first terminal and a second terminal, and the first terminal of the passive network being connected to the first transmission line. The apparatus may include a second transmission line connected to the second terminal of the passive network, and a passive filter having a first terminal and a second terminal with the first terminal of the passive filter being connected to the second transmission line. The apparatus may include a third transmission line connected to the second terminal of the passive filter, and a receiver amplifier connected to the third transmission line and configured to receive a second set of RF signals from the antenna. The apparatus may include a switch having a first conductive terminal, a second conductive terminal, and a control terminal, the first conductive terminal being connected to the third transmission line, the second conductive terminal of the switch being coupled to a voltage reference, and the control terminal being configured to selectively enable the passive network to reduce either the first capacitive reactance or the second capacitive reactance by selectively electrically coupling the first conductive terminal to the second conductive terminal.

According to another example, the switch of the apparatus includes an N-channel metal oxide semiconductor field effect transistor and the voltage reference includes ground.

According to another example, the passive filter of the apparatus includes a capacitor. The capacitor may be configured as a direct current (DC) block to isolate the receiver amplifier from DC portions of the first set of radio frequency signals output by the transmitter amplifier.

According to another example, the passive network of the apparatus includes at least one inductor.

According to another example, the first capacitive reactance of the apparatus may be associated with the transmitter amplifier and the second capacitive reactance may be associated with the receiver amplifier.

An example embodiment of a system may include a processor configured to execute a plurality of instructions, a memory communicatively coupled to the processor and having a number of locations at which the plurality of instructions are readable by the processor, and a transceiver communicatively coupled to receive a first set of data from the processor and to provide a second set of data to the processor. The transceiver may include a transmitter amplifier having an output terminal communicatively coupled to a transmission line to output a first set of radio frequency (RF) signals to an antenna, and a receiver amplifier having an input terminal communicatively coupled to the transmission line to receive a second set of RF signals from the antenna. The transceiver may also include a passive network coupled between the transmitter amplifier and the receiver amplifier, the passive network being configurable to selectively cancel a first reactance of a parasitic capacitance of the transmitter amplifier or a second reactance of a parasitic capacitance of the receiver amplifier. The transceiver may also include a switch coupled between the input terminal and a voltage reference to selectively configure the passive network to cancel either the first reactance or the second reactance.

According to another example, the transmitter amplifier of the system may be configured to transmit the first set of RF signals at a range of frequencies including 2.39 Gigahertz and 2.5 Gigahertz.

According to another example, the receiver amplifier may be configured to amplifier the second set of RF signals at a range of frequencies including 2.39 Gigahertz and 2.5 Gigahertz.

According to another example, the transceiver may be configured to be compliant with Institute of Electrical and Electronics Engineers (IEEE) standard 802.11.

According to another example, the processor, the memory, and the transceiver may be integrated onto a single wireless communication interface card.

One example embodiment of a method may include providing a first plurality of radio frequency (RF) signals to an antenna from a an output terminal of a transmitter amplifier via a first communication path which is unimpeded by any active switches, and receiving a second plurality of RF signals from the antenna at an input terminal of a receiver amplifier via a second communication path which is unimpeded by any active switches. The method may also include selectively coupling, with a switch, a voltage reference to the input terminal of the receiver amplifier to enable a passive network to cancel a first capacitive reactance associated with the transmitter amplifier while providing the first plurality of RF signals from the output terminal to the antenna, and selectively tri-stating the output terminal of the transmitter amplifier while receiving the second plurality of RF signals at the input terminal of the receiver, wherein tri-stating the output terminal enables the passive network to cancel a second capacitive reactance associated with the receiver amplifier.

According to another example, the passive network includes an inductor.

According to another example, the method may include tri-stating the transmitter amplifier by decoupling one or more transistors of the transmitter amplifier from a voltage source, and decoupling the one or more transistors of the transmitter amplifier from the voltage reference.

## Claims

1. An apparatus, comprising:
a transmitter amplifier (102) having an output terminal (114) communicatively coupled to a transmission line to output a first set of radio frequency (RF) signals to an antenna (110);
a receiver amplifier (104) having an input terminal (118) communicatively coupled to the transmission line to receive a second set of RF signals from the antenna (110);
a passive network (106) coupled between the transmitter amplifier (102) and the receiver amplifier (104) and comprising a series inductor (122), the passive network being configurable to cancel either a first reactance of a parasitic capacitance of the transmitter amplifier (102) or second reactance of a parasitic capacitance of the receiver amplifier (104) in the series inductor (122) being configured to cancel said first and second reactances by impedance matching; and
a switch (108) coupled between the input terminal (118) and a voltage reference (124) to selectively configure the passive network (106) to cancel either the first reactance or the second reactance.

2. The apparatus of claim 1, further comprising:
a capacitor coupled between the passive network (106) and the input terminal (118), the capacitor being configured to substantially block propagation of direct current (DC) signals between the antenna (110) and the input terminal, wherein the switch (108) is coupled to the voltage reference (124) between the capacitor and the input terminal.

3. The apparatus of claim 1, wherein the output terminal (114) is electrically connected to a first terminal of the passive network (106), via the transmission line, without an intervening switch.

4. The apparatus of claim 3, wherein the input terminal (118) is electrically connected to a second terminal of the passive network (106) through a capacitor and via the transmission line.

5. The apparatus of any one of claims 1-4, wherein the transmitter amplifier (102) comprises a power amplifier; or
optionally, wherein the receiver amplifier (104) comprises a low noise amplifier; or
optionally, wherein the switch (108) is coupled between the input terminal (118) and the voltage reference (124) to selectively configure the passive network (106) to cancel either the first reactance or the second reactance, via electrical resonance.

6. The apparatus of any one of claims 1-4, wherein the voltage reference (124) includes either a direct current (DC) reference or an alternating current (AC) reference with a DC bias.

7. The apparatus of any one of claims 1 to 6, wherein
the transmission line comprises a first, a second and a third transmission line section,
the first transmission line section is connected to the output terminal (114) of the transmitter amplifier (102);
the passive network (106) has a first terminal and a second terminal, the first terminal of the passive network being connected to the first transmission line section,
the second transmission line section is connected to the second terminal of the passive network (106);
the apparatus comprises a passive filter having a first terminal and a second terminal, the first terminal of the passive filter being connected to the second transmission line;
the third transmission line section is connected to the second terminal of the passive filter;
the receiver amplifier (104) is connected to the third transmission line section; and
the switch (108) has a first conductive terminal (126), a second conductive terminal (108), and a control terminal (130), the first conductive terminal being connected to the third transmission line section, the second conductive terminal of the switch being coupled to the voltage reference (124), and the control terminal being configured to selectively enable the passive network to reduce either the first capacitive reactance or the second capacitive reactance by selectively electrically coupling the first conductive terminal to the second conductive terminal.

8. The apparatus of claim 7, wherein the switch (108) comprises an N-channel metal oxide semiconductor field effect transistor and the voltage reference (124) comprises ground.

9. The apparatus of claim 7, wherein the passive filter comprises a capacitor; and
optionally, wherein the capacitor is configured as a direct current (DC) block to isolate the receiver amplifier (104) from DC portions of the first set of radio frequency signals output by the transmitter amplifier (102).

10. A system, comprising
a processor configured to execute a plurality of instructions;
a memory communicatively coupled to the processor and having a number of locations at which the plurality of instructions are readable by the processor;
a transceiver (100) communicatively coupled to receive a first set of data from the processor and to provide a second set of data to the processor, the transceiver including an apparatus of any one of claims 1 to 9.

11. A method, comprising:
providing a first plurality of radio frequency (RF) signals to an antenna (110) from a an output terminal (114) of a transmitter amplifier (102) via a first communication path which is unimpeded by any active switches;
receiving a second plurality of RF signals from the antenna (110) at an input terminal (118) of a receiver amplifier (104) via a second communication path which is unimpeded by any active switches;
selectively coupling, with a switch (108), a voltage reference (124) to the input terminal (118) of the receiver amplifier (104) to enable a passive network (106) to cancel a first capacitive reactance associated with the transmitter amplifier (102) while providing the first plurality of RF signals from the output terminal (114) to the antenna (110), wherein the passive network is coupled between the transmitter amplifier (102) and the receiver amplifier (104) and includes a series inductor; and
selectively tri-stating the output terminal (114) of the transmitter amplifier (102) while receiving the second plurality of RF signals at the input terminal (118) of the receiver amplifier (104), wherein tri-stating the output terminal (114) enables the passive network (106) to cancel a second capacitive reactance associated with the receiver amplifier (104).

12. The method of claim 11, wherein tri-stating the transmitter amplifier includes:
decoupling one or more transistors of the transmitter amplifier (102) from a voltage source; and
decoupling the one or more transistors of the transmitter amplifier (102) from the voltage reference (124).

## Patentansprüche

1. Vorrichtung, umfassend:
einen Senderverstärker (102) mit einem Ausgangsanschluss (114), der kommunikativ mit einer Übertragungsleitung gekoppelt ist, um eine erste Menge von Hochfrequenz- bzw. HF-Signalen an eine Antenne (110) auszugeben;
einen Empfängerverstärker (104) mit einem Eingangsanschluss (118), der kommunikativ mit der Übertragungsleitung gekoppelt ist, um eine zweite Menge von HF-Signalen von der Antenne (110) zu empfangen;
ein passives Netzwerk (106), das zwischen den Senderverstärker (102) und den Empfängerverstärker (104) geschaltet ist und eine Reiheninduktivität (122) umfasst, wobei das passive Netzwerk dafür auslegbar ist, entweder eine erste Reaktanz einer parasitären Kapazität des Senderverstärkers (102) oder eine zweite Reaktanz einer parasitären Kapazität des Empfängerverstärkers (104) in der Reiheninduktivität (122) aufzuheben, das dafür ausgelegt ist, die erste und zweite Reaktanz durch Impedanzanpassung aufzuheben; und
einen Schalter (108), der zwischen den Eingangsanschluss (118) und eine Spannungsreferenz (124) geschaltet ist, um das passive Netzwerk (106) selektiv dafür zu konfigurieren, entweder die erste Reaktanz oder die zweite Reaktanz aufzuheben.

2. Vorrichtung nach Anspruch 1, ferner umfassend:
einen zwischen das passive Netzwerk (106) und den Eingangsanschluss (118) geschalteten Kondensator, wobei der Kondensator dafür ausgelegt ist, Ausbreitung von Gleichstrom- bzw. DC-Signalen zwischen der Antenne (110) und dem Eingangsanschluss im Wesentlichen zu blockieren, wobei der Schalter (108) mit der Spannungsreferenz (124) zwischen dem Kondensator und dem Eingangsanschluss gekoppelt ist.

3. Vorrichtung nach Anspruch 1, wobei der Ausgangsanschluss (114) elektrisch ohne einen dazwischentretenden Schalter über die Übertragungsleitung mit einem ersten Anschluss des passiven Netzwerks (106) verbunden ist.

4. Vorrichtung nach Anspruch 3, wobei der Eingangsanschluss (118) mittels eines Kondensators und über die Übertragungsleitung elektrisch mit einem zweiten Anschluss des passiven Netzwerks (106) verbunden ist.

5. Vorrichtung nach einem der Ansprüche 1-4, wobei der Senderverstärker (102) einen Leistungsverstärker umfasst; oder
wobei gegebenenfalls der Empfängerverstärker (104) einen rauscharmen Verstärker umfasst; oder
wobei gegebenenfalls der Schalter (108) zwischen den Eingangsanschluss (118) und die Spannungsreferenz (124) geschaltet ist, um das passive Netzwerk (106) selektiv dafür zu konfigurieren, entweder die erste Reaktanz oder die zweite Reaktanz über elektrische Resonanz aufzuheben.

6. Vorrichtung nach einem der Ansprüche 1-4, wobei die Spannungsreferenz (124) entweder eine Gleichstrom- bzw. DC-Referenz oder eine Wechselstrom- bzw. AC-Referenz mit DC-Vorspannung umfasst.

7. Vorrichtung nach einem der Ansprüche 1 bis 6, wobei
die Übertragungsleitung einen ersten, einen zweiten und einen dritten Übertragungsleitungsabschnitt umfasst,
der erste Übertragungsleitungsabschnitt mit
dem Ausgangsanschluss (114) des Senderverstärkers (102) verbunden ist;
das passive Netzwerk (106) einen ersten Anschluss und einen zweiten Anschluss aufweist, wobei der erste Anschluss des passiven Netzwerks mit dem ersten Übertragungsleitungsabschnitt verbunden ist,
der zweite Übertragungsleitungsabschnitt mit dem zweiten Anschluss des passiven Netzwerks (106) verbunden ist;
die Vorrichtung ein passives Filter mit einem ersten Anschluss und einem zweiten Anschluss umfasst, wobei der erste Anschluss des passiven Filters mit der zweiten Übertragungsleitung verbunden ist;
der dritte Übertragungsleitungsabschnitt mit dem zweiten Anschluss des passiven Filters verbunden ist;
der Empfängerverstärker (104) mit dem dritten Übertragungsleitungsabschnitt verbunden ist; und
der Schalter (108) einen ersten leitfähigen Anschluss (126), einen zweiten leitfähigen Anschluss (108) und einen Steueranschluss (130) aufweist, wobei der erste leitfähige Anschluss mit dem dritten Übertragungsleitungsabschnitt verbunden ist, der zweite leitfähige Anschluss des Schalters mit der Spannungsreferenz (124) gekoppelt ist und der Steueranschluss ausgelegt ist, das passive Netzwerk selektiv dazu zu befähigen, entweder die erste kapazitive Reaktanz oder die zweite kapazitive Reaktanz durch selektives elektrisches Koppeln des ersten leitfähigen Anschlusses mit dem zweiten leitfähigen Anschluss zu verringern.

8. Vorrichtung nach Anspruch 7, wobei der Schalter (108) einen n-Kanal-Metalloxidhalbleiter-Feldeffekttransistor umfasst und die Spannungsreferenz (124) Masse umfasst.

9. Vorrichtung nach Anspruch 7, wobei das passive Filter einen Kondensator umfasst; und
wobei gegebenenfalls der Kondensator als eine Gleichstrom- bzw. DC-Blockierung ausgelegt ist, um den Empfängerverstärker (104) von DC-Teilen der ersten Menge von durch den Senderverstärker (102) ausgegebenen Hochfrequenzsignalen zu isolieren.

10. System, umfassend:
einen Prozessor, der dafür ausgelegt ist, mehrere Anweisungen auszuführen;
einen Speicher, der kommunikativ mit dem Prozessor gekoppelt ist und eine Anzahl von Stellen aufweist, an denen die mehreren Anweisungen durch den Prozessor lesbar sind;
einen Sendeempfänger (100), der kommunikativ so geschaltet ist, dass er eine erste Menge von Daten von einem Prozessor empfängt und dem Prozessor eine zweite Menge von Daten zuführt, wobei der Sendeempfänger eine Vorrichtung nach einem der Ansprüche 1 bis 9 umfasst.

11. Verfahren, umfassend:
Leiten einer ersten Vielzahl von Hochfrequenz- bzw. HF-Signalen zu einer Antenne (110) von einem Ausgangsanschluss (114) eines Senderverstärkers (102) über einen ersten Kommunikationspfad, der durch keinerlei aktive Schalter behindert wird;
Empfangen einer zweiten Vielzahl von HF-Signalen von der Antenne (110) an einem Eingangsanschluss (118) eines Empfängerverstärkers (104) über einen zweiten Kommunikationspfad, der durch keinerlei aktive Schalter behindert wird;
selektives Koppeln einer Spannungsreferenz (124) mit dem Eingangsanschluss (118) des Empfängerverstärkers (104) mit einem Schalter (108), um ein passives Netzwerk (106) dazu zu befähigen, eine dem Senderverstärker (102) zugeordnete erste kapazitive Reaktanz aufzuheben, während die erste Vielzahl von HF-Signalen von dem Ausgangsanschluss (114) der Antenne (110) zugeführt wird, wobei das passive Netzwerk zwischen den Senderverstärker (102) und den Empfängerverstärker (104) geschaltet ist und eine Reiheninduktivität umfasst; und
selektives Tri-Stating des Ausgangsanschlusses (114) des Senderverstärkers (102), während die zweite Vielzahl von HF-Signalen an dem Eingangsanschluss (118) des Empfängerverstärkers (104) empfangen wird, wobei Tri-Stating des Ausgangsanschlusses (114) das passive Netzwerk (106) dazu befähigt, eine dem Empfängerverstärker (104) zugeordnete zweite kapazitive Reaktanz aufzuheben.

12. Verfahren nach Anspruch 11, wobei Tri-Stating des Senderverstärkers Folgendes umfasst:
Entkoppeln eines oder mehrerer Transistoren des Senderverstärkers (102) von einer Spannungsquelle; und
Entkoppeln des einen oder der mehreren Transistoren des Senderverstärkers (102) von der Spannungsreferenz (124).

## Revendications

1. Appareil, comprenant :
un amplificateur émetteur (102) ayant une borne de sortie (114) couplée de manière communicante à une ligne de transmission pour produire en sortie un premier ensemble de signaux radiofréquence (RF) vers une antenne (110) ;
un amplificateur récepteur (104) ayant une borne d'entrée (118) couplée de manière communicante à la ligne de transmission pour recevoir un second ensemble de signaux RF depuis l'antenne (110) ;
un réseau passif (106) couplé entre l'amplificateur émetteur (102) et l'amplificateur récepteur (104) et comprenant une bobine d'induction en série (122), le réseau passif étant configurable pour annuler soit une première réactance d'une capacité parasite de l'amplificateur émetteur (102), soit une seconde réactance d'une capacité parasite de l'amplificateur récepteur (104) dans la bobine d'induction en série (122) configurée pour annuler lesdites première et seconde réactances par adaptation d'impédance ; et
un commutateur (108) couplé entre la borne d'entrée (118) et une référence de tension (124) pour configurer sélectivement le réseau passif (106) afin d'annuler soit la première réactance, soit la seconde réactance.

2. Appareil selon la revendication 1, comprenant en outre :
un condensateur couplé entre le réseau passif (106) et la borne d'entrée (118), le condensateur étant configuré pour sensiblement bloquer la propagation de signaux de courant continu (C.C.) entre l'antenne (110) et la borne d'entrée, dans lequel le commutateur (108) est couplé à la référence de tension (124) entre le condensateur et la borne d'entrée.

3. Appareil selon la revendication 1, dans lequel la borne de sortie (114) est connectée électriquement à une première borne du réseau passif (106), par l'intermédiaire de la ligne de transmission, sans commutateur intermédiaire.

4. Appareil selon la revendication 3, dans lequel la borne d'entrée (118) est connectée électriquement à une seconde borne du réseau passif (106) par le biais d'un condensateur et par l'intermédiaire de la ligne de transmission.

5. Appareil selon l'une quelconque des revendications 1 à 4, dans lequel l'amplificateur émetteur (102) comprend un amplificateur de puissance ; ou
facultativement, dans lequel l'amplificateur récepteur (104) comprend un amplificateur à faible bruit ; ou
facultativement, dans lequel le commutateur (108) est couplé entre la borne d'entrée (118) et la référence de tension (124) pour configurer sélectivement le réseau passif (106) afin d'annuler soit la première réactance, soit la seconde réactance, par résonnance électrique.

6. Appareil selon l'une quelconque des revendications 1 à 4, dans lequel la référence de tension (124) comporte soit une référence de courant continu (C.C.), soit une référence de courant alternatif (C.A.) à polarisation C.C.

7. Appareil selon l'une quelconque des revendications 1 à 6, dans lequel
la ligne de transmission comprend une première, deuxième et troisième section de ligne de transmission, la première ligne de transmission section est connectée à la borne de sortie (114) de l'amplificateur émetteur (102) ;
le réseau passif (106) comporte une première borne et une seconde borne, la première borne du réseau passif étant connectée à la première section de ligne de transmission,
la seconde section de ligne de transmission est connectée à la seconde borne du réseau passif (106) ; l'appareil comprend un filtre passif comportant une première borne et une seconde borne, la première borne du filtre passif étant connectée à la seconde ligne de transmission ;
la troisième section de ligne de transmission est connectée à la seconde borne du filtre passif ; l'amplificateur récepteur (104) est connecté à la troisième section de ligne de transmission ; et
le commutateur (108) comporte une première borne conductrice (126), une seconde borne conductrice (108), et une borne de commande (130), la première borne conductrice étant connectée à la troisième section de ligne de transmission, la seconde borne conductrice du commutateur étant couplée à la référence de tension (124), et la borne de commande étant configurée pour permettre de configurer la borne de commande afin de permettre sélectivement au réseau passif de réduire soit la première réactance capacitive, soit la seconde réactance capacitive en couplant sélectivement électriquement la première borne conductrice à la seconde borne conductrice.

8. Appareil selon la revendication 7, dans lequel le commutateur (108) comprend un transistor à effet de champ à métal-oxyde à canal N et la référence de tension (124) comprend la terre.

9. Appareil selon la revendication 7, dans lequel le filtre passif comprend un condensateur ; et
, dans lequel le condensateur est configuré en tant que bloc à courant continu (DC) pour isoler l'amplificateur récepteur (104) des parties C.C. du premier ensemble de signaux radiofréquence produits en sortie par l'amplificateur émetteur (102).

10. Système, comprenant
processeur configuré pour exécuter une pluralité d'instructions ;
une mémoire couplée de manière communicante au processeur et comportant un nombre d'emplacements auxquels la pluralité d'instructions peut être lue par le processeur ;
un émetteur-récepteur (100) couplé de manière communicante pour recevoir un premier ensemble de données depuis le processeur et fournir un second ensemble de données au processeur, l'émetteur-récepteur comportant un appareil selon l'une quelconque des revendications 1 à 9.

11. Procédé, comprenant :
la fourniture d'une première pluralité de signaux radiofréquence (RF) à une antenne (110) depuis une borne de sortie (114) d'un amplificateur émetteur (102) par l'intermédiaire d'un premier chemin de communication qui est non affecté par un quelconque commutateur actif ;
la réception d'une seconde pluralité de signaux RF depuis l'antenne (110) à une borne d'entrée (118) d'un amplificateur récepteur (104) par l'intermédiaire d'un second chemin de communication qui est non affecté par un quelconque commutateur actif ;
le couplage sélectif, avec un commutateur (108), d'une référence de tension (124) à la borne d'entrée (118) de l'amplificateur récepteur (104) pour permettre à un réseau passif (106) d'annuler une première réactance capacitive associée à l'amplificateur émetteur (102) tout en fournissant la première pluralité de signaux RF provenant de la borne de sortie (114) à l'antenne (110), dans lequel le réseau passif comporte une bobine d'induction ; et
la mise en état de haute impédance sélective de la borne de sortie (114) de l'amplificateur émetteur (102) pendant la réception de la seconde pluralité de signaux RF à la borne d'entrée (118) de l'amplificateur récepteur (104), dans lequel la mise en état de haute impédance de la borne de sortie (114) permet au réseau passif (106) de supprimer une seconde réactance capacitive associée à l'amplificateur récepteur (104).

12. Procédé selon la revendication 11, dans lequel la mise en état de haute impédance de l'amplificateur émetteur comporte :
le découplage d'un ou plusieurs transistors de l'amplificateur émetteur (102) d'une source de tension ; et
le découplage d'un ou plusieurs transistors de l'amplificateur émetteur (102) de la référence de tension (124).
